# EUROPÄISCHE PATENTANMELDUNG

(11) **EP 1 575 078 A1**
(43) Veröffentlichungstag der Anmeldung: **14.09.2005**
(21) Anmeldenummer: 05005020.2
(22) Anmeldetag: 08.03.2005
(51) Int. Cl.: H01J 37/32, C23C 14/38, C23C 14/56, C23C 14/02

(54) **Verfahren zur Oberflächenbehandlung von Substraten**

(30) Priorität: 08.03.2004 DE 102004011178
(71) Anmelder: Fraunhofer-Gesellschaft zur Förderung der angewandten Forschung e.V., 80686 München (DE)
(72) Erfinder: Jung, Thomas, Dr. rer.nat., 38173 Hötzum (DE)
(74) Vertreter: Pfenning, Meinig & Partner GbR

(57) **Zusammenfassung**

Die Erfindung betrifft ein Verfahren zur Oberflächenbehandlung von bandförmigen Substraten bei der eine Hohlkathoden-Glimmentladung eingesetzt wird, wobei der Entladungsraum durch das Substrat und mindestens eine Gegenelektrode definiert ist.

## Beschreibung

Die Erfindung betrifft ein Verfahren zur Oberflächenbehandlung von bandförmigen Substraten bei der eine Hohlkathoden-Glimmentladung eingesetzt wird, wobei der Entladungsraum durch das Substrat und mindestens eine Gegenelektrode definiert ist.

Verfahren zur Oberflächenbehandlung von ebenen Substraten mittels plasmagestützten Verfahren sind bekannt. Der Vorteil derartiger Verfahren ist darin zu sehen, dass aufgrund der hohen Teilchenenergien Oberflächenmodifizierungen und/oder Beschichtungen möglich sind, die mit anderen Verfahren nicht darstellbar sind. Bekannte Verfahren zur plasmagestützten Oberflächenbehandlung, insbesondere fortlaufend bewegten Bändern sind das Magnetronsputtern und das inverse Magnetronätzen. Mittels Magnetronsputtern können dünne anorganische Schichten aufgetragen werden, mit dem inversen Magnetronätzen können dünne Oberflächenschichten und Verunreinigungen abgetragen werden, beispielsweise zur Verbesserung der Haftung nachfolgender Beschichtungen.

Nachteilig bei diesen Verfahren ist, dass der verfahrenstechnische Aufwand durch die Verwendung eines Magnetfeldes groß ist.

Ein weiterer entscheidender Nachteil dieser Verfahren ist darin zu sehen, dass hierbei nur im unteren Feinvakuumbereich, d. h. bis maximal 10⁻² mbar gearbeitet werden kann. Dies bringt mit sich, dass in der Regel nur eine geringe Plasmadichte erzeugt wird und die Geschwindigkeit einer Plasmareinigung oder Plasmabeschichtung der Substratoberfläche daher sehr niedrig ist. Außerdem ist ein hoher Aufwand für die benötigte Vakuumtechnik erforderlich.

Die vorstehend beschriebenen Verfahren des Standes der Technik sind weiterhin deshalb ungünstig, weil dadurch z. B. die Oberflächenbehandlung von laufenden Bändern problematisch ist. Die hohe Bandlaufgeschwindigkeit von z. B. Stahlblech in der Größenordnung von bis zu 100 m/min erfordert nämlich sehr hohe stationäre Beschichtungsraten und Plasmadichten, die mit einem Verfahren wie vorstehend beschrieben, d. h. mit dem Magnetronsputtern bzw. mit dem Magnetronätzen nicht möglich sind. Außerdem sind diese Verfahren bei starker Ausgasung des Bandmaterials nicht einsetzbar, beispielsweise bei der Behandlung textiler Bänder.

Aus der DE 197 44 060 A1 ist ein Verfahren und eine Vorrichtung zur Oberflächenbehandlung von Substraten bekannt. Der Entladungsbereich nach diesem Verfahren wird dabei durch die zu behandelnden Substratoberflächen zumindest auf zwei im Wesentlichen gegenüberliegende Seiten begrenzt. Mit diesem Verfahren ist zwar eine relativ hohe Plasmadichte möglich, jedoch ist diese nicht geeignet, um insbesondere bei schnell laufenden Bändern dünne metallische Schichten abzuscheiden.

Ausgehend hiervon ist es deshalb die Aufgabe der vorliegenden Erfindung, ein neues Verfahren zur Oberflächenbehandlung von Substraten in Bandform anzugeben, bei dem die Oberfläche der bandförmigen Substrate sowohl abgetragen werden kann als auch eine Beschichtung möglich ist, beispielsweise mit Metall. Das Verfahren soll weiterhin einfach zu betreiben sein.

Die Aufgabe wird durch die kennzeichnenden Merkmale des Patentanspruches 1 gelöst. Die Unteransprüche zeigen vorteilhafte Weiterbildungen auf.

Erfindungsgemäß wird somit ein Verfahren vorgeschlagen, bei dem die Oberflächenbehandlung mittels einer Hohlkathoden-Glimmentladung durchgeführt wird. Dadurch kann die Behandlung bei einem Druck im oberen Feinvakuumbereich bis hin zum atmosphärischem Druck (0,01 mbar bis 1000 mbar) erfolg. Die Hohlkathode wird dabei aus dem Band und mindestens einer weiteren Gegenelektrode gebildet, die gemeinsam den Entladungsraum umschließen.

Die Ausbildung der Hohlkathodenentladung erfolgt dadurch, dass an das bandförmige Substrat und die Gegenelektrode eine Spannung angelegt wird. Die Spannung zwischen dem bandförmigen Substrat und der Gegenelektrode einerseits und einem aufgrund der elektrischen Entladung ausgebildeten Plasma andererseits beträgt zwischen 100 bis 1000 V. Als Gleichspannungen kommen auch gepulste Gleichspannungen mit einer Pulsfrequenz zwischen 10 kHz und 400 kHz in Frage. Bei Verwendung von niederfrequenten Wechselspannungen liegt die Frequenz bevorzugt zwischen 50 und 60 Hz und bei mittelfrequenter Wechselspannung bevorzugt zwischen 10 und 100 kHz. Hochfrequente Wechselspannungen weisen bevorzugt Frequenzen zwischen 1 und 27 MHz auf.

Wird beim erfindungsgemäßen Verfahren ein schlecht oder nicht leitendes bandförmiges Substrat eingesetzt, so wird die Spannung an das Band über eine rückwärtige Elektrode auf der das Band aufliegt, angelegt.

Der große Vorteil des erfindungsgemäßen Verfahrens ist darin zu sehen, dass durch die Anordnung des bandförmigen Substrates zur Gegenelektrode und dem dadurch gebildeten Entladungsraum eine große Variabilität in den Verfahrensbedingungen möglich ist. Die Ausbildung der Hohlkathodenentladung erfolgt nun dadurch, indem eine gleich- oder ähnlichgroße Spannung an das bandförmige Substrat und an die Gegenelektrode angelegt wird. Wird an das Band eine höhere Spannung angelegt als an die Gegenelektrode, so kommt es zum verstärkten Abtragen, d. h. Ätzen des Bandes. Wird an die Gegenelektrode eine höhere Spannung als an das Band angelegt, so kommt es zur verstärkten Kathodenzerstäubung der Gegenelektrode, wobei sich das abgestäubte Kathodenmaterial teilweise auf dem Band niederschlägt und dort eine Schicht bildet.

Gemäß der vorliegenden Erfindung ist es selbstverständlich auch möglich, das Verfahren so durchzuführen, dass mehr als eine Hohlkathoden-Glimmentladung durchgeführt wird, wobei in diesen Fällen das bandförmige Substrat die beiden Hohlkathodenentladungen nacheinander durchläuft. Ein derartiges Verfahren kann dann z. B. so betrieben werden, dass ein Abtragen von Oberflächenschichten oder Oberflächenverunreinigungen erfolgt und dass dann eine zweite Hohlkathodenentladung so verfahrenstechnisch betrieben wird, dass eine Abscheidung von Material, d. h. eine Beschichtung stattfindet.

Das Verfahren ist selbstverständlich auch so durchführbar, dass mittels einer Hohlkathodenentladung zuerst eine Abtragung und nachfolgend eine Abscheidung, d. h. eine Beschichtung erfolgt.

Beim erfindungsgemäßen Verfahren ist es selbstverständlich wie bei den Verfahren des Standes der Technik möglich, dass in den Entladungsraum zur Oberflächenbehandlung der bandförmigen Substrate ein Reaktivgas zugeführt wird. Als reaktive Gase kommen z. B. oxidierende, reduzierende, kohlenstoffhaltige oder siliziumhaltige Gase wie Sauerstoff, Wasserstoff, Stickstoff, Methan, Ethin, Silan, Hexamethyldisiloxan, Tetramethylsilan usw. in Frage. Mit Hilfe der reaktiven Gase können z. B. Schichten aufgetragen, Material abgetragen oder in die Oberflächenbereiche Gasbestandteile integriert werden. So lassen sich Substratoberflächen von Verunreinigungen wie Schmierstoffen, Korrosionsschutzmitteln oder Oxidschichten reinigen oder mit Korrosionsschutzschichten, Haftvermittlerschichten für nachfolgende Beschichtungen, Gleitschichten zur Verbesserung der Umformeigenschaften oder dekorative Schichten versehen.

Als Arbeitsgas wird beim erfindungsgemäßen Verfahren mit Edelgas, Stickstoff oder Wasserstoff oder Mischungen hiervon gearbeitet.

Eine weitere Möglichkeit das erfindungsgemäße Verfahren zu variieren besteht darin, die Gegenelektrode in ihrer Geometrie unterschiedlich auszugestalten. Bevorzugt ist die Gegenelektrode als ebene Platte, als konkav gekrümmte Platte, als konvex gekrümmte Platte, als Rolle oder als Netz ausgebildet.

Bei zu starker Aufheizung kann die Gegenelektrode selbstverständlich auch gekühlt werden. Weiterhin ist es möglich, die Gegenelektrode mit Vertiefungen auszustatten.

Für das erfindungsgemäße Verfahren ist es weiterhin wichtig, dass der Abstand zwischen dem bandförmigen Substrat und der mindestens einen Gegenelektrode im Bereich von 1 mm bis 20 mm liegt.

Das erfindungsgemäße Verfahren kann besonders angewendet werden zur Oberflächenreinigung, Oberflächenmodifizierung oder Beschichtung von Band oder Folien aus Metall, Kunststoff oder Textil. Auch eignet sich das Verfahren hervorragend zur Verbesserung der Haftfestigkeit einer nachfolgenden Beschichtung.

Besonders ist das Verfahren geeignet zur Verbesserung der Benetzung von Stahlband bei der Schmelztauchbeschichtung. Das erfindungsgemäße Verfahren wird dabei so durchgeführt, dass auf dem Stahlband zuerst vorhandene Oxidschichten aktiviert und/oder abgetragen werden und gleichzeitig und/oder anschließend eine metallische Haftschicht aufgebracht wird.

Weitere Vorteile und Weiterbildungen der Erfindung ergeben sich aus den Figuren und dem nachfolgenden Ausführungsbeispiel. Es zeigen:
- Fig. 1:: den schematischen Aufbau des erfindungsgemäßen Verfahrens mit einer flächigen Gegenelektrode und einem bandförmigen Substrat.
- Fig. 2:: den schematischen Aufbau einer weiteren Variante des erfindungsgemäßen Verfahrens bei dem eine rückwärtige Elektrode auf das Band aufgebracht ist.
- Fig. 3:: eine weitere Ausführungsform des erfindungsgemäßen Verfahrens unter Verwendung einer Gegenelektrode als Rolle.
- Fig. 4:: eine weitere Ausführungsform bei der das bandförmige Substrat über eine Bandführungsrolle geführt wird.
- Fig. 5.:: die Durchführung des erfindungsgemäßen Verfahrens, wobei eine Gegenelektrode mit Vertiefungen verwendet wird.

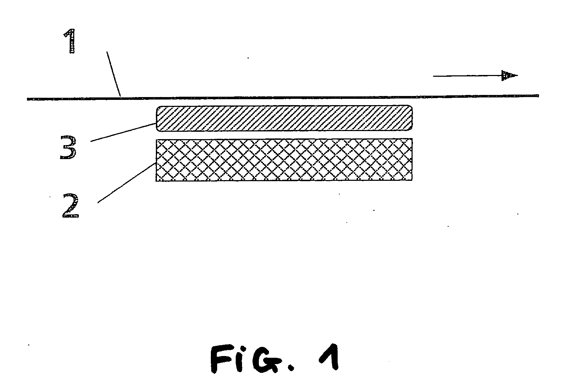

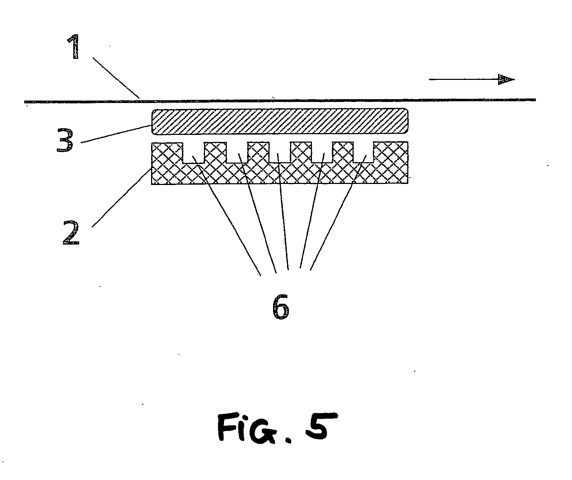

Die gesamten in den Fign. 1 bis 5 dargestellten Anordnungen sind gegebenenfalls zusammen mit den Spulen zur Auf- und Abwicklung des Bandes bzw. der Bänder, in nicht dargestellten Vakuumkammern untergebracht. Bei Verwendung von bandförmigen Substraten kann das Substrat auch über außerhalb der Vakuumkammer angeordneten Spulen und Vakuumschleusen zum und aus dem Entladungsbereich 3 gefördert werden.

Bei den in den Fig. 1 bis 5 dargestellten Substraten 1 handelt es sich um 0,1 mm starkes und 50 cm breites, bandförmiges und kontinuierlich gefördertes Stahlband. Bei zu starker Aufheizung kann das behandelte bandförmige Substrat 1 während der Oberflächenbehandlung gekühlt werden. Die Kühlung kann durch einen Kühlkörper, der von einem flüssigen oder gasförmigen Kühlmedium durchströmt wird, und im direkten mechanischen Kontakt zum Substrat steht, erfolgen.

Beim Ausführungsbeispiel nach der Fig. 1 wird der Entladungsraum 3 durch eine flächige Gegenelektrode 2 und das bandförmige Substrat 1 gebildet.

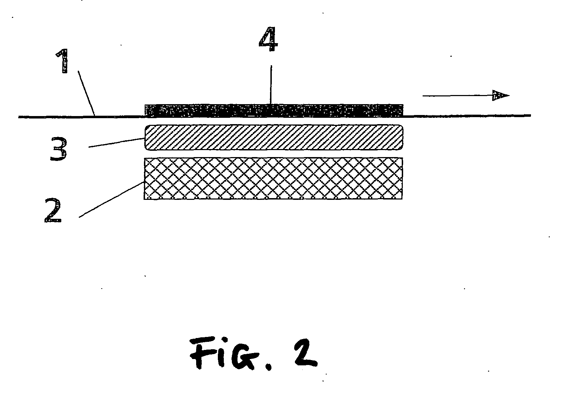

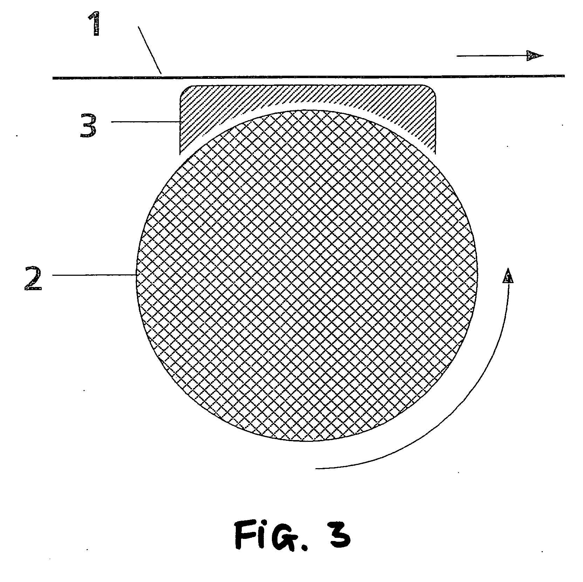

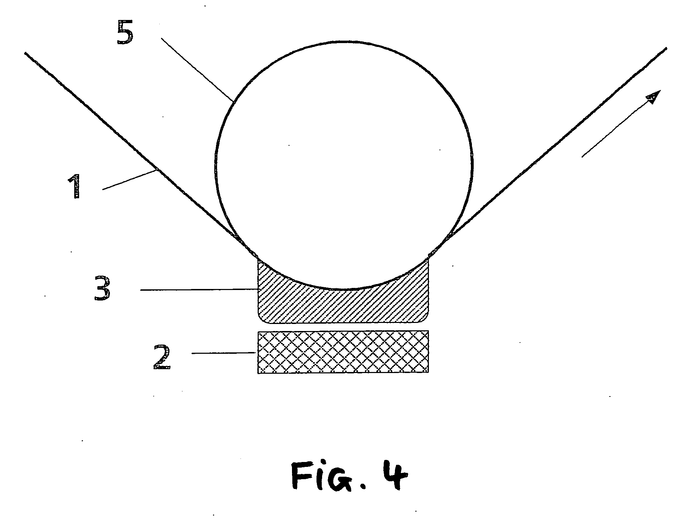

In Abwandlung des Ausführungsbeispiels nach der Fig. 1 zeigt die Fig. 2 eine Ausführungsform identisch mit der nach Fig. 1, jedoch erfolgt hier das Anlegen der Spannung über das Band über eine rückwärtige Elektrode 4 auf der das Band aufliegt. Dies ist immer dann notwendig, wenn ein elektrisch schlecht oder nicht leitfähiges Band eingesetzt wird. Eine weitere Variante des erfindungsgemäßen Verfahrens ist in der Fig. 3 dargestellt. Gemäß der Ausführungsform nach der Fig. 3 wird eine rollenförmige Gegenelektrode 2 eingesetzt, die während des Betriebes kontinuierlich rotiert werden kann, wodurch sukzessive neue Oberflächenbereiche der Gegenelektrode dem Plasma ausgesetzt werden. Abweichend hiervon zeigt das Ausführungsbeispiel nach der Fig. 4 ein Verfahrensbeispiel bei der wiederum eine flächige Gegenelektrode 2 verwendet wird, jedoch dann das bandförmige Substrat 1 über eine Bandführungsrolle geführt wird. Dadurch ändert sich die Geometrie des Entladungsraumes 3 in umgekehrter Form wie sie in Fig. 3 dargestellt ist.

Letztlich zeigt die Ausführungsform nach Fig. 4 noch die Abwandlung des erfindungsgemäßen Verfahrens in der Weise, dass als Gegenelektrode eine Gegenelektrode eingesetzt wird, die Vertiefungen aufweist.

### Ausführungsbeispiel

Behandelt wird eine Kunststofffolie von 20 *µ*m Dicke. Die Folie wird mit einer Geschwindigkeit von 1 m/s durch zwei aufeinander folgende Anordnungen gemäß Fig. 4 geführt. In den Räumen zwischen dem Kunststoffband 1 und den beiden Gegenelektroden 2 befindet sich Argon mit einem Druck von 0,3 mbar. Der Abstand zwischen dem Kunststoffband und den Gegenelektroden beträgt 2 cm.

An die erste Rolle 5 wird gegenüber einer nicht dargestellten Anode (beispielsweise in Gestalt der metallischen Vakuumkammer, in der die sich Anordnung befindet) eine mit 60 kHz gepulste negative Gleichspannung von 500 V gelegt. Die gleiche Spannung wird auch an die erste Gegenelektrode 2 gelegt. Dadurch entsteht im Raum zwischen der Rolle und der Gegenelektrode eine Hohlkathodenglimmentladung und deren Plasma 3. Im Ergebnis der Plasmaeinwirkung wird die Oberfläche der Kunststofffolie durch Aufbrechen chemischer Bindungen so aktiviert, dass eine nachfolgend aufgebrachte Beschichtung sehr gut anhaftet.

Das Band durchläuft nun die zweite Anordnung gemäß Fig. 4. Hier wird an die Rolle 5 eine mit 60 kHz gepulste negative Gleichspannung von 300 V gelegt, während an die Gegenelektrode 2 eine negative gepulste Gleichspannung von 600 V angelegt wird. Die Gegenelektrode besteht aus Kupfer und ist wassergekühlt. Durch die hohe Gleichspannung an der Gegenelektrode kommt es zur Kathodenzerstäubung, und das dabei abgetragene Material schlägt sich zum großen Teil auf der Kunststofffolie nieder. Auf diese Weise wird die Kunststofffolie mit einer dünnen Kupferschicht von einigen Nanometern Dicke beschichtet. Auf dieser Oberfläche lassen sich beispielsweise weitere Schichten haftfest aufbringen, zum Beispiel auch auf elektrochemischem Wege.

## Patentansprüche

1. Verfahren zur Oberflächenbehandlung von Substraten in Bandform, mit mindestens einer Hohlkathoden-Glimmentladung, wobei die mindestens eine Hohlkathoden-Glimmentladung durch eine Hohlkathode, deren Entladungsraum durch das bandförmige Substrat und mindestens eine Gegenelektrode definiert ist, erzeugt wird und die elektrische Entladung im Bereich von 0,01 mbar bis 1000 mbar durchgeführt wird.

2. Verfahren nach Anspruch 1,
**dadurch gekennzeichnet, dass** an das bandförmige Substrat und die Gegenelektrode eine Spannung angelegt wird.

3. Verfahren nach Anspruch 1 oder 2,
**dadurch gekennzeichnet, dass** die Spannung zwischen dem bandförmigen Substrat und der Gegenelektrode einerseits und einem aufgrund der elektrischen Entladung ausgebildeten Plasma andererseits 100 bis 1000 V beträgt.

4. Verfahren nach einem der Ansprüche 1 bis 3,
**dadurch gekennzeichnet, dass** im Falle von schlecht- oder nichtleitenden bandförmigen Substraten die Spannung an das Band über eine rückwärtige Elektrode auf der das Band aufliegt, angelegt wird.

5. Verfahren nach einem der Ansprüche 1 bis 4,
**dadurch gekennzeichnet, dass** der Arbeitsdruck des Verfahrens im Bereich von 0,1 mbar bis 10 mbar liegt.

6. Verfahren nach einem der Ansprüche 1 bis 5,
**dadurch gekennzeichnet,**
**dass** die Entladung durch eine Gleichspannung, eine gepulste Gleichspannung oder durch eine nieder-, mittel-, oder hochfrequente Wechselspannung aktiviert oder unterstützt wird.

7. Verfahren nach Anspruch 6,
**dadurch gekennzeichnet, dass** die Frequenz 50 Hz bis 27 MHz beträgt.

8. Verfahren nach einem der Ansprüche 1 bis 7,
**dadurch gekennzeichnet,**
**dass** der Entladungsraum der durch das bandförmige Substrat und die mindestens eine Gegenelektrode begrenzt wird, einen Abstand von 1 mm bis 20 mm aufweist.

9. Verfahren nach einem der Ansprüche 1 bis 8,
**dadurch gekennzeichnet, dass** an das Substrat und die Gegenelektrode eine annähernd gleichgroße Spannung angelegt wird.

10. Verfahren nach einem der Ansprüche 1 bis 8,
**dadurch gekennzeichnet,**
**dass** zum Abtrag von Oberflächenschichten und/oder Oberflächenverunreinigungen an das bandförmige Substrat eine höhere Spannung als an die Gegenelektrode angelegt wird.

11. Verfahren nach einem der Ansprüche 1 bis 8,
**dadurch gekennzeichnet, dass** zum Abscheiden vom Material der Gegenelektrode mittels Kathodenzerstäubung an die Gegenelektrode eine höhere Spannung angelegt wird als an das bandförmige Substrat.

12. Verfahren nach mindestens einem der Ansprüche 1 bis 11,
**dadurch gekennzeichnet, dass** mit zwei separaten Hohlkathodenentladungen gearbeitet wird, die das bandförmige Substrat nacheinander durchläuft.

13. Verfahren nach Anspruch 12,
**dadurch gekennzeichnet, dass** eine Hohlkathodenentladung so betrieben wird, dass ein Abtragen von Oberflächenschichten oder Oberflächenverunreinigungen erfolgt und die zweite Hohlkathodenentladung so betrieben wird, dass eine Abscheidung von Material, d. h. eine Beschichtung erfolgt.

14. Verfahren nach mindestens einem der Ansprüche 1 bis 13,
**dadurch gekennzeichnet, dass** mittels einer Hohlkathodenentladung ein Abtragen und ein Abscheiden, d.h. eine Beschichtung, erfolgt.

15. Verfahren nach einem der Ansprüche 1 bis 14,
**dadurch gekennzeichnet, dass** in den Entladungsraum zur Oberflächenbehandlung der bandförmigen Substrate ein Reaktivgas zugeführt wird.

16. Verfahren nach einem der Ansprüche 1 bis 15,
**dadurch gekennzeichnet, dass** mit Edelgas, Stickstoff oder Wasserstoff oder Mischungen hiervon als Arbeitsgas gearbeitet wird.

17. Verfahren nach mindestens einem der Ansprüche 1 bis 16,
**dadurch gekennzeichnet, dass** die Gegenelektrode als ebene Platte, als konkav gekrümmte Platte, als konvex gekrümmte Platte, als Rolle oder als Netz ausgebildet ist.

18. Verfahren nach einem der Ansprüche 1 bis 17,
**dadurch gekennzeichnet, dass** die Gegenelektrode gekühlt wird.

19. Verfahren nach einem der Ansprüche 1 bis 17,
**dadurch gekennzeichnet, dass** die Gegenelektrode gekühlt wird.

20. Verwendung des Verfahrens nach einem der Ansprüche 1 bis 19, zur Oberflächenreinigung, Oberflächenmodifizierung oder Beschichtung von Band oder Folien aus Metall, Kunststoff oder Textil.

21. Verwendung des Verfahrens nach einem der Ansprüche 1 bis 19, zur Verbesserung der Haftfestigkeit einer nachfolgenden Beschichtung.

22. Verfahren nach einem der Ansprüche 1 bis 19, zur Verbesserung der Benetzung von Stahlband bei der Schmelztauchbeschichtung, indem auf dem Stahlband vorhandene Oxidschichten aktiviert und/oder abgetragen werden und gleichzeitig und/oder anschließend eine metallische Haftschicht aufgebracht wird.
